# EUROPEAN PATENT APPLICATION

(11) **EP 4 663 678 A1**
(43) Date of publication of application: **17.12.2025**
(21) Application number: 23921376.2
(22) Date of filing: 22.12.2023
(51) Int. Cl.: C08G 59/32, C08G 77/60, H05K 3/28

(54) **RESIN COMPOSITION, RESIN COATING, DRY FILM, AND RESIN CURED PRODUCT**

(30) Priority: 06.02.2023 JP 2023016293
(71) Applicant: SHIN-ETSU CHEMICAL CO., LTD., Tokyo 1000005 (JP)
(72) Inventor: MARUYAMA Hitoshi, Annaka-shi Gunma 379-0224 (JP)
(74) Representative: Ter Meer Steinmeister & Partner
(86) International application number: PCT/JP2023/046169
(87) International publication number: WO 2024/166558

(57) **Abstract**

This resin composition comprises (A) a polymer wherein the main chain contains a silphenylene backbone, an epoxy group-containing isocyanuric acid backbone, and a norbornane backbone and (B) an epoxy curing accelerator, and is heat cured to yield a resin cured product having a relative dielectric constant of 2.5 or less at 10 GHz and a dielectric loss tangent of 0.005 or less at 10 GHz.

## Description

### TECHNICAL FIELD

The present invention relates to a resin composition, a resin coating, a dry film and a cured resin product.

### BACKGROUND ART

Recently, in the semiconductor industry, in order to achieve high-frequency compatibility in smart phones and other mobile devices, there has been a desire for semiconductor encapsulating materials having lower dielectric constants. Epoxy resins have been commonly used to date as semiconductor encapsulants. Of these, semiconductor encapsulants in the form of silicone resin-containing dry films having a support film and a resin coating on the support film which are capable of flatly and hermetically sealing without void incorporation the top of a substrate having uneven surface features such as chips and interconnects have been described (Patent Document 1).

However, in cell phones and other mobile communication devices, network infrastructure devices such as base station equipment, servers and routers, and electronic equipment such as mainframe computers, the speed and capacity of the signals used increase from year to year. This trend is accompanied by a need for further reductions in transmission loss. Hence, there exists a desire for even lower dielectric properties in semiconductor encapsulants.

### PRIOR ART DOCUMENTS

### PATENT DOCUMENTS

Patent Document 1: JP-A 2021-95524

### SUMMARY OF INVENTION

### TECHNICAL PROBLEM

The present invention was arrived at in light of the above circumstances. One object of the invention is a resin composition which provides a cured resin product having good adhesion to the base materials in substrates, electronic components, semiconductor devices and the like, particularly the base materials used in circuit boards, excellent reliability as a coating for protecting electrical and electronic components, low relative permittivity and dielectric loss tangent, and little warpage. A further object of the invention is a resin coating obtained from the resin composition. A still further object is a dry film having a support film and, on the support film, the above resin coating.

### SOLUTION TO PROBLEM

The inventor has conducted intensive investigations aimed at achieving the above objects, discovering as a result that these objects can be achieved with a resin composition comprising (A) a polymer that includes, on a main chain, a silphenylene skeleton, an epoxy group-containing isocyanuric acid skeleton and a norbornane skeleton, and (B) an epoxy curing accelerator. This discovery ultimately led to the present invention.

Accordingly, the invention provides the following resin composition, resin coating, dry film and cured resin product.
1. A resin composition comprising:
   (A) a polymer that includes, on a main chain, a silphenylene skeleton, an epoxy group-containing isocyanuric acid skeleton and a norbornane skeleton, and
   (B) an epoxy curing accelerator,
   which composition, when heat-cured, gives a cured resin product having a relative permittivity at 10 GHz of 2.5 or less and a dielectric loss tangent at 10 GHz of 0.005 or less.
2. The resin composition of 1 above, wherein the polymer (A) has repeating units of formula (A1) below and repeating units of formula (A2) below 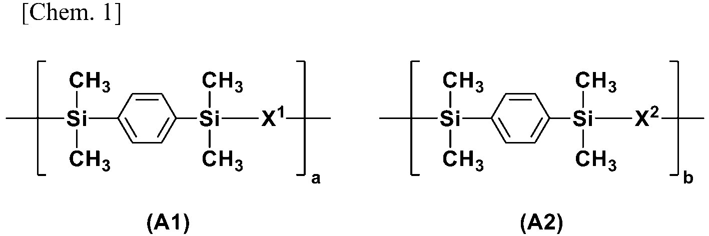 (wherein a and b are positive numbers that satisfy the conditions 0 < a < 1, 0 < b < 1 and a+b = 1, X¹ is a divalent group of formula (X1) below and X² is a divalent group of formula (X2) below 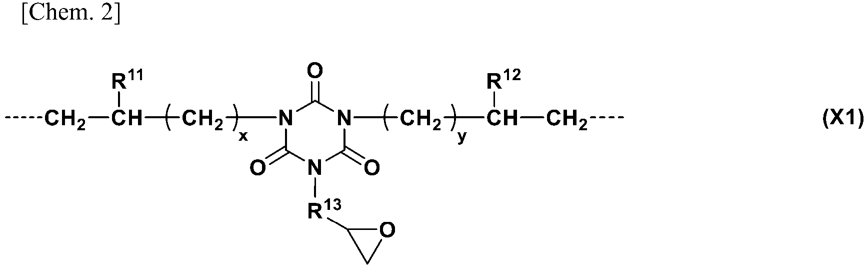 (wherein R¹¹ and R¹² are each independently a hydrogen atom or a methyl group, R¹³ is a hydrocarbylene group of 1 to 8 carbon atoms which may have an intervening ester bond or ether bond between a carbon-carbon bond, x and y are each independently integers from 0 to 7, and the dashed lines represent bonds) 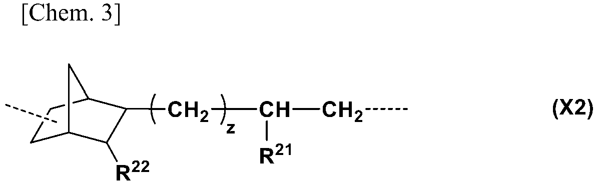 (wherein R²¹ and R²² are each independently a hydrogen atom or a saturated hydrocarbyl group of 1 to 20 carbon atoms which may include a heteroatom, z is an integer from 0 to 10, and the dashed lines represent bonds)).
3. The resin composition of 1 or 2 above, wherein the epoxy curing accelerator (B) is included in an amount of from 0.01 to 10 parts by weight per 100 parts by weight of the polymer (A).
4. The resin composition of any of 1 to 3 above, further including (C) a solvent.
5. The resin composition of any of 1 to 4 above, wherein heat curing is carried out at a curing temperature of between 100°C and 250°C.
6. The resin composition of any of 1 to 5 above, which is a coating material for protecting electrical and electronic components.
7. A resin coating obtained from the resin composition of any of 1 to 6 above.
8. A dry film having a support film and, on the support film, the resin coating of 7 above.
9. A cured resin product obtained by heat-curing the resin coating of 7 at between 100°C and 250°C.

### ADVANTAGEOUS EFFECTS OF INVENTION

The resin composition of the invention, the resin coating obtained from this resin composition, and the dry film which has a support film and, on the support film, the above resin coating are able to provide a cured resin product having good adhesion to the base materials of substrates, electronic components, semiconductor devices and the like, particularly the base materials used in circuit boards, excellent reliability as a coating for protecting electrical and electronic components, low relative permittivity and dielectric loss tangent, and little warpage.

### DESCRIPTION OF EMBODIMENTS

### [Resin Composition]

The resin composition of the invention comprises (A) a polymer which includes, on a main chain: a silphenylene skeleton, an epoxy group-containing isocyanuric acid skeleton and a norbornane skeleton, and (B) an epoxy curing accelerator.

### [(A) Polymer]

The polymer of component (A) is a polymer which includes, on a main chain: a silphenylene skeleton, an epoxy group-containing isocyanuric acid skeleton and a norbornane skeleton.

The polymer is preferably one which includes recurring units of formula (A1) below (also referred to below as "recurring unit A1") and recurring units of formula (A2) below (also referred to below as "recurring unit A2").

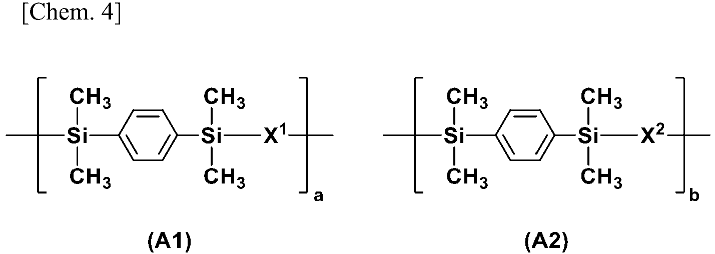

In formulas (A1) and (A2), a and b are positive numbers which satisfy the conditions 0 < a < 1, 0 < b < 1 and a+b = 1, although a preferably satisfies 0 < a ≤ 0.35. When a is within this range, the solubility in general-purpose organic solvents is excellent and the composition is easy to handle.

In formula (A1), X¹ is a divalent group of formula (X1) below 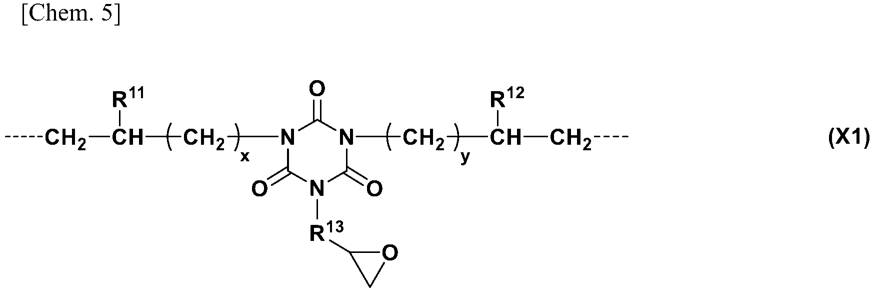 (wherein the dashed lines represent bonds).

In formula (X1), R¹¹ and R¹² are each independently a hydrogen atom or a methyl group. A hydrogen atom is preferred.

In formula (X1), R¹³ is a hydrocarbylene group of 1 to 8 carbon atoms which may have an intervening ester bond or ether bond between a carbon-carbon bond, although it is preferable for there to be no intervening ester bonds or ether bonds between carbon-carbon bonds. The hydrocarbylene group may be linear, branched or cyclic. Specific examples include the methylene group and alkanediyl groups such as the ethane-1,1-diyl, ethane-1,2-diyl, propane-1,2-diyl, propane-1,3-diyl, butane-1,2-diyl, butane-1,3-diyl and butane-1,4-diyl groups. Of these, R¹³ is preferably a methylene group or an ethane-1,2-diyl group. A methylene group is more preferred.

In formula (X1), x and y are each independently an integer from 0 to 7. An integer from 0 to 2 is preferred.

In formula (A2), X² is a divalent group of formula (X2) below 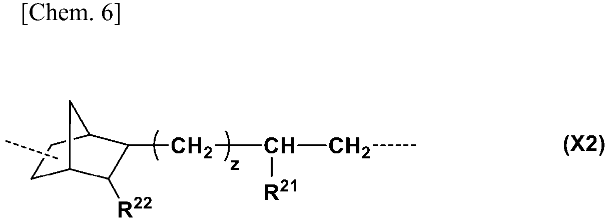 (wherein the dashed lines represent bonds).

In formula (X2), R²¹ and R²² are each independently a hydrogen atom or a saturated hydrocarbyl group of 1 to 20 carbon atoms which may include a heteroatom. The saturated hydrocarbyl group may be linear, branched or cyclic. Specific examples include alkyl groups of 1 to 20 carbon atoms, such as methyl, ethyl, n-propyl, isopropyl, n-butyl, isobutyl, sec-butyl, tert-butyl, n-pentyl, n-hexyl, n-heptyl, n-octyl, n-nonyl and n-decyl groups; and cyclic saturated hydrocarbyl groups of 3 to 20 carbon atoms, such as cyclopropyl, cyclobutyl, cyclopentyl, cyclohexyl, norbornyl and adamantyl groups. The saturated hydrocarbyl group may include a heteroatom. Specifically, some or all hydrogen atoms on the saturated hydrocarbyl group may be substituted with halogen atoms such as fluorine, chlorine, bromine or iodine atoms, or carbonyl groups, ether bonds, thioether bonds or the like may be interposed between carbon-carbon atoms thereon. R²¹ and R²² are preferably hydrogen atoms or methyl groups.

In formula (X2), z is an integer from 0 to 10. An integer from 0 to 2 is preferred.

The polymer of component (A) has a weight-average molecular weight (Mw) of preferably from 3,000 to 100,000, and more preferably from 5,000 to 50,000. At a Mw within this range, a tack-free polymer that is solid and has excellent flexibility can be obtained. Moreover, formation into a dry film having a protective film is also possible. In this invention, the Mw is a polystyrene-equivalent measured value obtained by gel permeation chromatography (GPC) using tetrahydrofuran as the eluting solvent.

The polymer of component (A) may be one in which recurring units A1 and A2 are randomly bonded, one in which they are alternately bonded, or one which includes a plurality of blocks of the respective units.

The polymer of component (A) is one which includes, as a silicon atom-containing skeleton, a silphenylene skeleton. From the standpoint of the dielectric properties, the absence of a siloxane skeleton is preferred. It is especially preferable for the silicon atom-containing skeleton to be composed solely of a silphenylene skeleton.

The polymer of component (A) serves as an ingredient which imparts a dry film-forming ability.

The polymer of component (A) may be of one type used alone or two or more may be used together.

### [Polymer Preparation]

The above polymeric compound can be prepared by addition polymerizing a compound of formula (1) below, a compound of formula (2) below and a compound of formula (3) below in the presence of a metal catalyst. 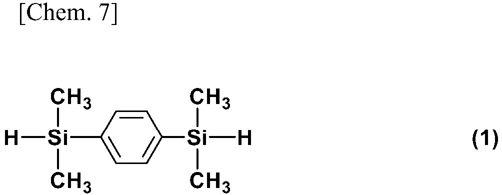 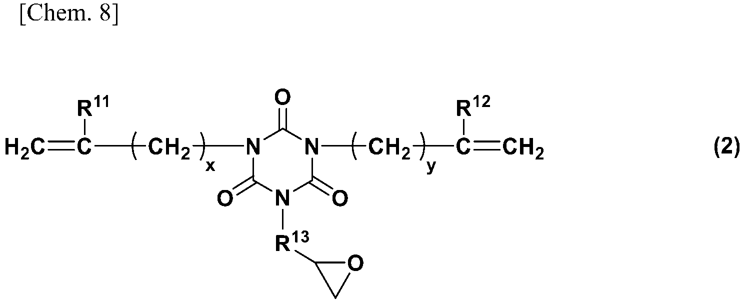 (wherein R¹¹ to R¹³, x and y are the same as above) 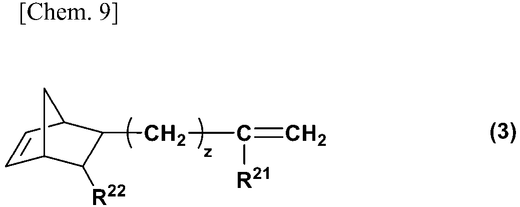 (wherein R²¹, R²² and z are the same as above)

Any of the following may be used as the metal catalyst: uncombined platinum group metals such as platinum (including platinum black), rhodium and palladium; platinum chloride, chloroplatinic acid and chloroplatinic acid salts, such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂ and Na₂HPtCl₄·xH₂O (wherein x is preferably an integer from 0 to 6, and is most preferably 0 or 6); alcohol-modified chloroplatinic acids (e.g., those mentioned in U.S. Pat. No. 3,220,972); complexes of chloroplatinic acid and olefins (e.g., those mentioned in U.S. Pat. Nos. 3,159,601, 3,159,662 and 3,775,452); platinum group metals such as platinum black or palladium on a support such as alumina, silica or carbon; rhodium-olefin complexes; chlorotris(triphenylphosphine)rhodium (so-called Wilkinson's catalyst); and complexes of platinum chloride, chloroplatinic acid or chloroplatinic acid salt with a vinyl group-containing siloxane (particularly vinyl group-containing cyclic siloxanes).

The catalyst is used in a catalytic amount, this being typically, in terms of the platinum group metal, from 0.001 to 0.1 wt% of the combined amount of the compound of formula (1), the compound of formula (2) and the compound of formula (3). If necessary, a solvent may be used in the polymerization reaction. The solvent is preferably a hydrocarbon-type solvent such as toluene or xylene. With regard to the polymerization conditions, to enable polymerization to go to completion in a short time and without deactivation of the catalyst, the polymerization temperature is preferably between 40°C and 150°C, and more preferably between 60°C and 120°C. The polymerization time depends also on the type and amount of the polymer. However, to prevent the introduction of moisture into the polymerization system, it is preferable for polymerization to be completed in from about 0.5 hour to about 100 hours, especially from 0.5 to 30 hours. Following completion of the polymerization reaction in this way, the polymer can be obtained by, in cases where a solvent has been used, driving off the solvent by distillation.

The reaction method is not particularly limited, although it is desirable to first mix together and heat the compound of formula (2) and the compound of formula (3), then add the metal catalyst to the mixed solution, and subsequently add in a dropwise manner the compound of formula (1) over a period of from 0.1 hour to 5 hours.

It is desirable to formulate the respective starting compounds such that the molar ratio of hydrosilyl groups on the compound of formula (1) with respect to the sum of the carbon-carbon double bonds on the compound of formula (2) and the compound of formula (3) is preferably from 0.67 to 1.67, and more preferably from 0.83 to 1.25. It is possible to control the Mw of the polymer of the invention by using a monoallyl compound such as o-allyl phenol, a monohydrosilane such as triethylhydrosilane or a monohydrosiloxane as the molecular weight modifier.

### [(B) Epoxy Curing Accelerator]

With regard to the epoxy curing accelerator serving as component (B), wide use may be made of ones which can be used in the ring opening of epoxy groups. Examples of such curing accelerators include imidazoles such as imidazole, 2-methylimidazole, 2-ethylimidazole, 2-heptadecylimidazole, 1,2-dimethylimidazole, 2-ethyl-4-methylimidazole, 2-undecylimidazole, 2-phenylimidazole, 2-phenyl-4-methylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 2-phenyl-4,5-dihydroxymethylimidazole and 2-phenyl-4-methyl-5-hydroxymethylimidazole; tertiary amines such as 2-ethyl-4-methylimidazole, 2-(dimethylaminomethyl)phenol, triethylenediamine, triethanolamine, 1,8-diazabicyclo[5.4.0]undecene-7 and tris(dimethylaminomethyl)phenol; organophosphines such as diphenylphosphine, triphenylphosphine and tributylphosphine; tetra-substituted phosphonium tetra-substituted borates such as tetraphenylphosphonium tetraphenylborate and tetraphenylphosphonium ethyltriphenylborate; and metal compounds such as tin octoate.

The content of component (B) per 100 parts by weight of component (A) is preferably from 0.01 to 10 parts by weight, and more preferably from 0.1 to 5.0 parts by weight. Within this range, the curing reaction proceeds optimally. The epoxy curing accelerator of component (B) may be of one type used alone or two or more may be used in combination.

### [(C) Solvent]

The resin composition of the invention may further include a solvent as component (C). The solvent is not particularly limited, provided that it is a solvent capable of dissolving components (A) and (B), although organic solvents are preferred because of their excellent ability to dissolve these ingredients.

Examples of the organic solvents include ketones such as cyclohexanone, cyclopentanone and methyl-2-n-pentyl ketone; alcohols such as 3-methoxybutanol, 3-methyl-3-methoxybutanol, 1-methoxy-2-propanol and 1-ethoxy-2-propanol; ethers such as propylene glycol monomethyl ether (PGME), ethylene glycol monomethyl ether, propylene glycol monoethyl ether, ethylene glycol monoethyl ether, propylene glycol dimethyl ether and diethylene glycol dimethyl ether; and esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate and γ-butyrolactone. Ethyl lactate, cyclohexanone, cyclopentanone, PGMEA, γ-butyrolactone and mixed solvents thereof are especially preferred.

From the standpoints of compatibility and viscosity, the amount of component (C) used per 100 parts by weight of component (A) is preferably from 50 to 2,000 parts by weight, more preferably from 50 to 1,000 parts by weight, and most preferably from 50 to 100 parts by weight. The organic solvent of component (C) may be of one type used alone, or two or more may be used in admixture.

The resin composition of the invention may be prepared by a conventional method. For example, the composition can be prepared by stirring and mixing together the above ingredients and subsequently, if necessary, using a filter or the like to filter off and remove solid matter.

### [Resin Coating]

A resin coating can be obtained by applying the resin composition of the invention onto a substrate made of a base material such as silicon, glass or a metal (e.g., iron, copper, nickel, aluminum) and, if necessary, subsequently evaporating off the solvent by carrying out a prebake. The prebake may be carried out at, for example, between 40°C and 140°C for a period of from about 1 minute to about 1 hour. The method of application may be a known method, such as dip coating, spin coating or roll coating. The resin composition is applied in an amount which may be suitably selected according to the intended object, although application such that the resulting resin coating has a thickness of preferably from 0.1 to 200 µm, and more preferably from 1 to 150 µm, is desirable.

### [Dry Film]

The dry film of the invention has a support film and, on the support film, a resin coating obtained from the above-described resin composition.

The dry film (support film and resin coating) is a solid. Because the resin coating does not include a solvent, there is no risk of bubbles caused by solvent volatilization remaining within the resin coating and between the resin coating and an uneven substrate.

From the standpoint of the flatness, step coverage and substrate stacking interval on an uneven substrate, the resin coating has a thickness of preferably from 5 to 200 µm, and more preferably from 10 to 100 µm.

The viscosity and flowability of the resin coating are closely related. Within a suitable viscosity range, the resin coating can exhibit suitable flowability, enabling penetration deep into narrow gaps and, with softening of the resin, enabling adhesion with the substrate to be strengthened. Therefore, from the standpoint of its flowability, the resin coating has a viscosity at between 80°C and 120°C which is preferably from 10 to 5,000 Pa·s, more preferably from 30 to 2,000 Pa·s, and even more preferably from 50 to 300 Pa·s. In this invention, viscosity is a measured value obtained with a rotational viscometer.

When the dry film of the invention is bonded to an uneven substrate, the resin coating conforms to and covers the uneven features, enabling a high flatness to be achieved. In particular, this resin coating is characterized by a low viscoelasticity, enabling an even higher flatness to be achieved. Furthermore, when the resin coating is bonded to the substrate in a vacuum environment, the formation of gaps therebetween can be more effectively prevented.

The dry film of the invention can be produced by applying the resin composition dissolved in a solvent onto a support film and drying the applied composition to form a resin coating. A film coater commonly used for producing pressure-sensitive adhesive products can be used as the dry film manufacturing unit. Examples of such film coaters include comma coaters, comma reverse coaters, multi-coaters, die coaters, lip coaters, lip reverse coaters, direct gravure coaters, offset gravure coaters, three-roll bottom reverse coaters and four-roll bottom reverse coaters.

The dry film can be produced by unwinding a support film from the unwind shaft of the film coater and passing it through the coater head of the film coater while coating the support film with the resin composition to a predetermined thickness, and subsequently passing the support film with resin composition thereon through a circulating hot-air oven at a predetermined temperature for a predetermined length of time so as to dry the composition on the support film and thereby form a resin coating. Alternatively, where necessary, a dry film with protective film can be produced by passing the dry film, together with a protective film that has been unwound from another unwind shaft of the film coater, through a laminate roll under a predetermined pressure and laminating the resin coating on the support film with the protective film, then winding the resulting laminate onto the take-up shaft of the film coater. In this case, the temperature is preferably between 25°C and 150°C, the time is preferably from 1 to 100 minutes, and the pressure is preferably from 0.01 to 5 MPa.

The support film may be a one-layer film composed of a single film, or may be a multilayer film composed of a plurality of stacked films. Examples of the film material include synthetic resins such as polyethylene, polypropylene, polycarbonate and polyethylene terephthalate. Of these, for a suitable flexibility, mechanical strength and heat resistance, polyethylene terephthalate is preferred. These films may be ones which have been subjected to various treatments, such as corona treatment or the application of a stripping agent. Commercial products may be used as these films. Examples include Cerapeel WZ(RX) and Cerapeel BX8(R) (from Toray Advanced Film Co., Ltd.), E7302 and E7304 (Toyobo Co., Ltd.), Purex G31 and Purex G71T1 (Teijin Dupont Film Japan Ltd.), and PET38×1-A3, PET38×1-V8 and PET38×1-X08 (from Nippa Co., Ltd.).

A film similar to the above-described support film may be used as the protective film. Polyethylene terephthalate and polyethylene are preferred because they have a suitable flexibility. Commercial products may be used as the protective film. Examples of polyethylene terephthalate protective films include those already mentioned; examples of polyethylene protective films include GF-8 (Tamapoly Co., Ltd.) and PE Film 0 Type (Nippa Co., Ltd.).

From the standpoint of the stability of dry film production, the tendency of the film to retain the curvature of the roll core, and curl prevention, the support film and the protective film both have thicknesses of preferably from 10 to 100 µm, and more preferably from 25 to 50 µm.

The method of laminating the dry film of the invention onto a flat or uneven substrate is not particularly limited. For example, the method used may be one which involves peeling off the protective film bonded to the dry film, using a vacuum laminator from Takatori Corporation (product name, TEAM-300) to collectively bring the resin film to which a support film has been bonded into close contact with the substrate within a vacuum chamber set to a vacuum of from 50 to 1,000 Pa, preferably from 50 to 500 Pa, such as 100 Pa, and a temperature of between 80°C and 200°C, preferably between 80°C and 130°C, such as 100°C, then reverting back to normal pressure and subsequently cooling the substrate to room temperature, removing it from the vacuum laminator and peeling off the support film.

### [Cured Product]

A cured product can be obtained by using an oven or a hot plate to heat cure, preferably at between 100°C and 250°C, more preferably at between 150°C and 230°C, the resin coating formed by applying a solution of the resin composition onto a substrate and drying the composition or the resin coating formed by bonding the dry film onto a substrate. The heat curing time is preferably from 10 minutes to 10 hours, and more preferably from 10 minutes to 4 hours. At a curing temperature of between 100°C and 250°C, a cured resin product can be obtained that has a high adhesive strength to substrates, electronic components, semiconductor devices and the like, especially substrates used in circuit boards, an excellent reliability as a coating for protecting electrical and electronic components, a low relative permittivity and dielectric loss tangent, and little warpage.

The resin coating and dry film obtained from the above resin composition can be suitably used as, for example, encapsulants such as protective films for semiconductor devices.

### EXAMPLES

Synthesis Examples, Examples of the invention and Comparative Examples are given below by way of illustration, although the invention is not limited by these Examples. Weight-average molecular weights (Mw) were measured by gel permeation chromatography (GPC) against a monodisperse polystyrene standard under the following conditions: TSKgel Super HZM-H column (Tosoh Corporation); flow rate, 0.6 mL/min; eluting solvent, THF; column temperature, 40°C.

### [1] Polymer Synthesis

The compounds that were used in polymer synthesis are shown below.

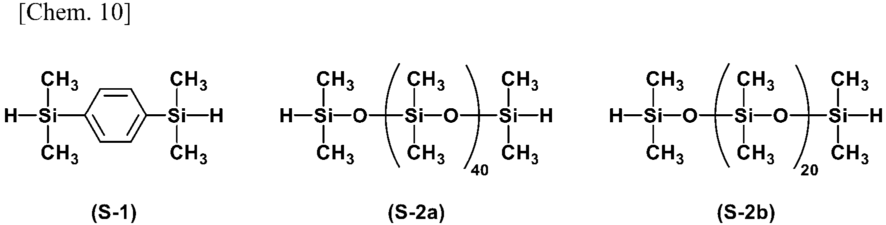

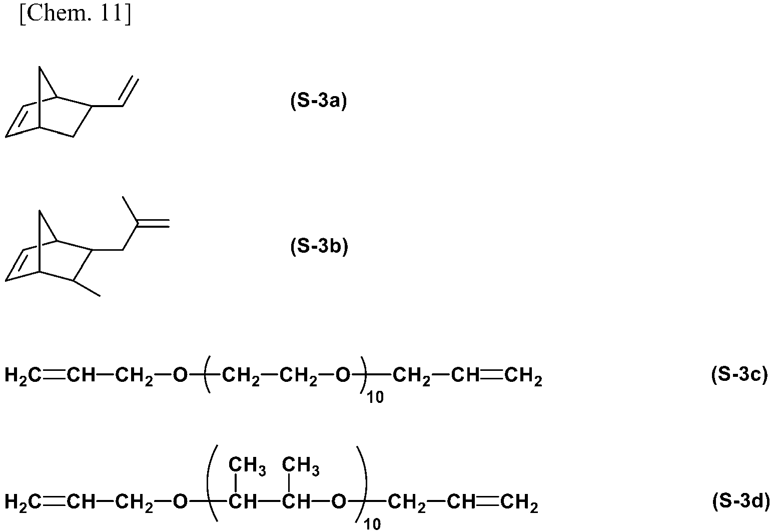

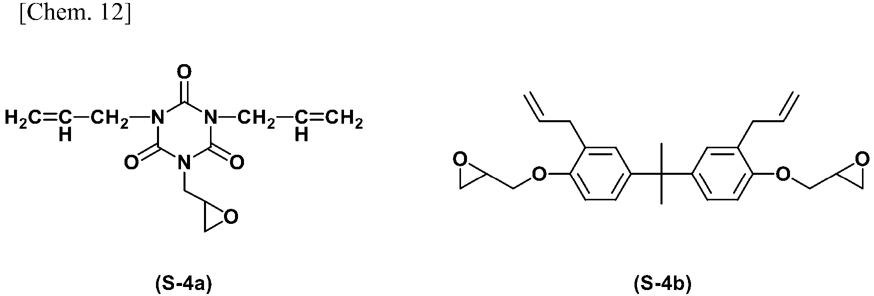

### [Synthesis Example 1] Synthesis of Polymer P-1

A ten-liter flask equipped with a stirrer, a thermometer, a nitrogen purging system and a reflux condenser was charged with 92.8 g (0.35 mol) of Compound (S-4a) and 105.3 g (0.65 mol) of Compound (S-3b), following which 2,000 g of toluene was added and the flask contents were heated to 70°C. Next, 1.0 g of a toluene solution of chloroplatinic acid (platinum concentration, 0.5 wt%) was poured in and 194.0 g (1.00 mol) of Compound (S-1) was added dropwise over one hour (sum of hydrosilyl groups/sum of carbon-carbon double bonds = 1/1 (molar ratio)). Following the completion of dropwise addition, the flask contents were heated to 100°C and aged for 2 hours, after which toluene was vacuum-distilled from the reaction solution, giving Polymer P-1. Polymer P-1 was confirmed to be a polymer having recurring units A1 and A2 because no peak near 4.5 ppm indicating the presence of SiH groups was detected in ¹H-NMR spectroscopy (Bruker), no peak near 2200 cm⁻¹ indicating the presence of SiH groups was detected in FT-IR spectroscopy (Shimadzu Corporation), and the weight-average molecular weight from GPC measurement was 4,000.

### [Synthesis Example 2] Synthesis of Polymer P-2

A ten-liter flask equipped with a stirrer, a thermometer, a nitrogen purging system and a reflux condenser was charged with 53.0 g (0.20 mol) of Compound (S-4a) and 96.8 g (0.80 mol) of Compound (S-3a), following which 2,000 g of toluene was added and the flask contents were heated to 70°C. Next, 1.5 g of a toluene solution of chloroplatinic acid (platinum concentration, 0.5 wt%) was poured in and 194.0 g (1.00 mol) of Compound (S-1) was added dropwise over one hour (sum of hydrosilyl groups/sum of carbon-carbon double bonds = 1/1 (molar ratio)). Following the completion of dropwise addition, the flask contents were heated to 100°C and aged for 8 hours, after which toluene was vacuum-distilled from the reaction solution, giving Polymer P-2. Polymer P-2 was confirmed to be a polymer having recurring units A1 and A2 because no peak near 4.5 ppm indicating the presence of SiH groups was detected in ¹H-NMR spectroscopy (Bruker), no peak near 2200 cm⁻¹ indicating the presence of SiH groups was detected in FT-IR spectroscopy (Shimadzu Corporation), and the weight-average molecular weight from GPC measurement was 41,000.

### [Synthesis Example 3] Synthesis of Polymer P-3

A ten-liter flask equipped with a stirrer, a thermometer, a nitrogen purging system and a reflux condenser was charged with 13.3 g (0.05 mol) of Compound (S-4a) and 115.0 g (0.95 mol) of Compound (S-3a), following which 2,000 g of toluene was added and the flask contents were heated to 70°C. Next, 2.0 g of a toluene solution of chloroplatinic acid (platinum concentration, 0.5 wt%) was poured in and 194.0 g (1.00 mol) of Compound (S-1) was added dropwise over one hour (sum of hydrosilyl groups/sum of carbon-carbon double bonds = 1/1 (molar ratio)). Following the completion of dropwise addition, the flask contents were heated to 100°C and aged for 20 hours, after which toluene was vacuum-distilled from the reaction solution, giving Polymer P-3. Polymer P-3 was confirmed to be a polymer having recurring units A1 and A2 because no peak near 4.5 ppm indicating the presence of SiH groups was detected in ¹H-NMR spectroscopy (Bruker), no peak near 2200 cm⁻¹ indicating the presence of SiH groups was detected in FT-IR spectroscopy (Shimadzu Corporation), and the weight-average molecular weight from GPC measurement was 83,000.

### [Comparative Synthesis Example 1] Synthesis of Comparative Polymer CP-1

A ten-liter flask equipped with a stirrer, a thermometer, a nitrogen purging system and a reflux condenser was charged with 26.5 g (0.10 mol) of Compound (S-4a) and 108.9 g (0.90 mol) of Compound (S-3a), following which 2,000 g of toluene was added and the flask contents were heated to 70°C. Next, 1.0 g of a toluene solution of chloroplatinic acid (platinum concentration, 0.5 wt%) was poured in and 184.3 g (0.95 mol) of Compound (S-1) and 9.3 g (0.05 mol) of Compound (S-2b) were added dropwise over one hour (sum of hydrosilyl groups/sum of carbon-carbon double bonds = 1/1 (molar ratio)). Following the completion of dropwise addition, the flask contents were heated to 100°C and aged for 6 hours, after which toluene was vacuum-distilled from the reaction solution, giving Comparative Polymer CP-1. The weight-average molecular weight of Comparative Polymer CP-1 was 15,000.

### [Comparative Synthesis Example 2] Synthesis of Comparative Polymer CP-2

A ten-liter flask equipped with a stirrer, a thermometer, a nitrogen purging system and a reflux condenser was charged with 238.5 g (0.90 mol) of Compound (S-4a) and 16.2 g (0.10 mol) of Compound (S-3b), following which 2,000 g of toluene was added and the flask contents were heated to 70°C. Next, 1.0 g of a toluene solution of chloroplatinic acid (platinum concentration, 0.5 wt%) was poured in and 184.3 g (0.95 mol) of Compound (S-1) and 79.3 g (0.05 mol) of Compound (S-2b) were added dropwise over one hour (sum of hydrosilyl groups/sum of carbon-carbon double bonds = 1/1 (molar ratio)). Following the completion of dropwise addition, the flask contents were heated to 100°C and aged for 6 hours, after which toluene was vacuum-distilled from the reaction solution, giving Comparative Polymer CP-2. The weight-average molecular weight of Comparative Polymer CP-2 was 7,000.

### [Comparative Synthesis Example 3] Synthesis of Comparative Polymer CP-3

A ten-liter flask equipped with a stirrer, a thermometer, a nitrogen purging system and a reflux condenser was charged with 79.5 g (0.30 mol) of Compound (S-4a) and 377.3 g (0.70 mol) of Compound (S-3c), following which 2,000 g of toluene was added and the flask contents were heated to 70°C. Next, 1.0 g of a toluene solution of chloroplatinic acid (platinum concentration, 0.5 wt%) was poured in and 174.6 g (0.90 mol) of Compound (S-1) and 158.5 g (0.10 mol) of Compound (S-2b) were added dropwise over one hour (sum of hydrosilyl groups/sum of carbon-carbon double bonds = 1/1 (molar ratio)). Following the completion of dropwise addition, the flask contents were heated to 100°C and aged for 6 hours, after which toluene was vacuum-distilled from the reaction solution, giving Comparative Polymer CP-3. The weight-average molecular weight of Comparative Polymer CP-3 was 83,000.

### [Comparative Synthesis Example 4] Synthesis of Comparative Polymer CP-4

A ten-liter flask equipped with a stirrer, a thermometer, a nitrogen purging system and a reflux condenser was charged with 132.5 g (0.50 mol) of Compound (S-4a) and 409.0 g (0.50 mol) of Compound (S-3d), following which 2,000 g of toluene was added and the flask contents were heated to 70°C. Next, 1.0 g of a toluene solution of chloroplatinic acid (platinum concentration, 0.5 wt%) was poured in and 174.6 g (0.90 mol) of Compound (S-1) and 302.0 g (0.10 mol) of Compound (S-2a) were added dropwise over one hour (sum of hydrosilyl groups/sum of carbon-carbon double bonds = 1/1 (molar ratio)). Following the completion of dropwise addition, the flask contents were heated to 100°C and aged for 6 hours, after which toluene was vacuum-distilled from the reaction solution, giving Comparative Polymer CP-4. The weight-average molecular weight of Comparative Polymer CP-4 was 103,000.

### [Comparative Synthesis Example 5] Synthesis of Comparative Polymer CP-5

A ten-liter flask equipped with a stirrer, a thermometer, a nitrogen purging system and a reflux condenser was charged with 26.5 g (0.10 mol) of Compound (S-4a), 163.6 g (0.20 mol) of Compound (S-3d) and 84.7 g (0.70 mol) of Compound (S-3a), following which 2,000 g of toluene was added and the flask contents were heated to 70°C. Next, 1.0 g of a toluene solution of chloroplatinic acid (platinum concentration, 0.5 wt%) was poured in and 194.0 g (1.00 mol) of Compound (S-1) was added dropwise over one hour (sum of hydrosilyl groups/sum of carbon-carbon double bonds = 1/1 (molar ratio)). Following the completion of dropwise addition, the flask contents were heated to 100°C and aged for 6 hours, after which toluene was vacuum-distilled from the reaction solution, giving Comparative Polymer CP-5. The weight-average molecular weight of Comparative Polymer CP-5 was 11,000.

### [Comparative Synthesis Example 6] Synthesis of Comparative Polymer CP-6

A ten-liter flask equipped with a stirrer, a thermometer, a nitrogen purging system and a reflux condenser was charged with 392.0 g (1.00 mol) of Compound (S-4b), following which 2,000 g of toluene was added and the flask contents were heated to 70°C. Next, 1.0 g of a toluene solution of chloroplatinic acid (platinum concentration, 0.5 wt%) was poured in and 194.0 g (1.00 mol) of Compound (S-1) was added dropwise over one hour (sum of hydrosilyl groups/sum of carbon-carbon double bonds = 1/1 (molar ratio)). Following the completion of dropwise addition, the flask contents were heated to 100°C and aged for 10 hours, after which toluene was vacuum-distilled from the reaction solution, giving Comparative Polymer CP-6. The weight-average molecular weight of Comparative Polymer CP-6 was 6,000.

### [Comparative Synthesis Example 7] Synthesis of Comparative Polymer CP-7

A ten-liter flask equipped with a stirrer, a thermometer, a nitrogen purging system and a reflux condenser was charged with 392.0 g (1.00 mol) of Compound (S-4b), following which 2,000 g of toluene was added and the flask contents were heated to 70°C. Next, 1.0 g of a toluene solution of chloroplatinic acid (platinum concentration, 0.5 wt%) was poured in and 174.6 g (0.90 mol) of Compound (S-1) and 158.5 g (0.10 mol) of Compound (S-2b) were added dropwise over one hour (sum of hydrosilyl groups/sum of carbon-carbon double bonds = 1/1 (molar ratio)). Following the completion of dropwise addition, the flask contents were heated to 100°C and aged for 6 hours, after which toluene was vacuum-distilled from the reaction solution, giving Comparative Polymer CP-7. The weight-average molecular weight of Comparative Polymer CP-7 was 36,000.

### [Comparative Synthesis Example 8] Synthesis of Comparative Polymer CP-8

A ten-liter flask equipped with a stirrer, a thermometer, a nitrogen purging system and a reflux condenser was charged with 117.6 g (0.30 mol) of Compound (S-4b) and 377.3 g (0.70 mol) of Compound (S-3c), following which 2,000 g of toluene was added and the flask contents were heated to 70°C. Next, 1.0 g of a toluene solution of chloroplatinic acid (platinum concentration, 0.5 wt%) was poured in and 194.0 g (1.00 mol) of Compound (S-1) was added dropwise over one hour (sum of hydrosilyl groups/sum of carbon-carbon double bonds = 1/1 (molar ratio)). Following the completion of dropwise addition, the flask contents were heated to 100°C and aged for 12 hours, after which toluene was vacuum-distilled from the reaction solution, giving Comparative Polymer CP-8. The weight-average molecular weight of Comparative Polymer CP-8 was 16,000.

### [Comparative Synthesis Example 9] Synthesis of Comparative Polymer CP-9

A ten-liter flask equipped with a stirrer, a thermometer, a nitrogen purging system and a reflux condenser was charged with 196.0 g (0.50 mol) of Compound (S-4b) and 60.5 g (0.50 mol) of Compound (S-3a), following which 2,000 g of toluene was added and the flask contents were heated to 70°C. Next, 1.0 g of a toluene solution of chloroplatinic acid (platinum concentration, 0.5 wt%) was poured in and 1,585.0 g (1.00 mol) of Compound (S-2b) was added dropwise over one hour (sum of hydrosilyl groups/sum of carbon-carbon double bonds = 1/1 (molar ratio)). Following the completion of dropwise addition, the flask contents were heated to 100°C and aged for 10 hours, after which toluene was vacuum-distilled from the reaction solution, giving Comparative Polymer CP-9. The weight-average molecular weight of Comparative Polymer CP-9 was 81,000.

### [Comparative Synthesis Example 10] Synthesis of Comparative Polymer CP-10

A ten-liter flask equipped with a stirrer, a thermometer, a nitrogen purging system and a reflux condenser was charged with 196.0 g (0.50 mol) of Compound (S-4b) and 269.5 g (0.50 mol) of Compound (S-3c), following which 2,000 g of toluene was added and the flask contents were heated to 70°C. Next, 1.0 g of a toluene solution of chloroplatinic acid (platinum concentration, 0.5 wt%) was poured in and 1,585.0 g (1.00 mol) of Compound (S-2b) was added dropwise over one hour (sum of hydrosilyl groups/sum of carbon-carbon double bonds = 1/1 (molar ratio)). Following the completion of dropwise addition, the flask contents were heated to 100°C and aged for 10 hours, after which toluene was vacuum-distilled from the reaction solution, giving Comparative Polymer CP-10. The weight-average molecular weight of Comparative Polymer CP-10 was 52,000.

### [2] Preparation of Resin Compositions

### [Examples 1 to 6 and Comparative Examples 1 to 10]

The resin compositions in Examples 1 to 6 and Comparative Examples 1 to 10 were prepared by compounding the ingredients according to the formulations shown in Tables 1 and 2, subsequently stirring and dissolving at room temperature, and then carrying out microfiltration with a 1.0 µm Teflon^{®} filter.

**[Table 1]**

| Ingredients | | | Example | | | | | |
|---|---|---|---|---|---|---|---|---|
| | | | 1 | 2 | 3 | 4 | 5 | 6 |
| (A) | Polymer | P-1 | 100 | - | - | 100 | - | - |
| | | P-2 | - | 100 | - | - | 100 | - |
| | | P-3 | - | - | 100 | - | - | 100 |
| | | CP-1 | - | - | - | - | - | - |
| | | CP-2 | - | - | - | - | - | - |
| | | CP-3 | - | - | - | - | - | - |
| | | CP-4 | - | - | - | - | - | - |
| | | CP-5 | - | - | - | - | - | - |
| | | CP-6 | - | - | - | - | - | - |
| | | CP-7 | - | - | - | - | - | - |
| | | CP-8 | - | - | - | - | - | - |
| | | CP-9 | - | - | - | - | - | - |
| | | CP-10 | - | - | - | - | - | - |
| (B) | Epoxy curing accelerator | B-1 | 2 | 2 | 2 | - | - | - |
| | | B-2 | - | - | - | 0.1 | 2 | 5 |
| (C) | Solvent | cyclopentanone | 55 | 55 | 55 | 55 | 55 | 55 |

**[Table 2]**

| Ingredients | | | Comparative Example | | | | | | | | | |
|---|---|---|---|---|---|---|---|---|---|---|---|---|
| | | | 1 | 2 | 3 | 4 | 5 | 6 | 7 | 8 | 9 | 10 |
| (A) | Polymer | P-1 | - | - | - | - | - | - | - | - | - | - |
| | | P-2 | - | - | - | - | - | - | - | - | - | - |
| | | P-3 | - | - | - | - | - | - | - | - | - | - |
| | | CP-1 | 100 | - | - | - | - | - | - | - | - | - |
| | | CP-2 | - | 100 | - | - | - | - | - | - | - | - |
| | | CP-3 | - | - | 100 | - | - | - | - | - | - | - |
| | | CP-4 | - | - | - | 100 | - | - | - | - | - | - |
| | | CP-5 | - | - | - | - | 100 | - | - | - | - | - |
| | | CP-6 | - | - | - | - | - | 100 | - | - | - | - |
| | | CP-7 | - | - | - | - | - | - | 100 | - | - | - |
| | | CP-8 | - | - | - | - | - | - | - | 100 | - | - |
| | | CP-9 | - | - | - | - | - | - | - | - | 100 | - |
| | | CP-10 | - | - | - | - | - | - | - | - | - | 100 |
| (B) | Epoxy curing accelerator | B-1 | 2 | - | 0.1 | - | 5 | 2 | 2 | 2 | - | - |
| | | B-2 | - | 2 | - | 0.1 | - | - | - | - | 2 | 2 |
| (C) | Solvent | cyclopentanone | 55 | 55 | 55 | 55 | 55 | 55 | 55 | 55 | 55 | 55 |

In Tables 1 and 2, epoxy curing accelerator B-1 is Curezol 2P4MHZ (Shikoku Chemicals Corporation; 2-phenyl-4-methyl-5-hydroxymethylimidazole), and B-2 is PURECAT TX-1 (San-Apro Ltd.; 1,8-diazabicyclo[5.4.0]undecane-7).

### [3] Dry Film Production

Using a die coater as the film coater and a polyethylene terephthalate film (thickness, 38 µm) as the support film, the resin compositions of Examples 1 to 6 and Comparative Examples 1 to 10 were each applied onto the support film. The applied resin composition was then dried by passing the coated film for 5 minutes through a circulating hot-air oven (length, 4 m) set to 100°C, thereby forming a resin coating on the support film and yielding a dry film. The thickness of each resin coating was set to 100 µm. The resin coating thickness was measured with an optical interference film thickness measurement system (F50-EXR, from Filmetrics, Inc.).

### [4] Resin Coating Evaluations

### (1) Evaluation of Warping Stress

The fabricated film was laminated onto an 8-inch silicon wafer using a film laminator (TEAM-100, from Takatori Corporation), after which the film was cured by heating in an oven at 230°C for 2 hours in Examples 1 and 2, at 150°C for 2 hours in Examples 5 and 6, and at 190°C for 2 hours in Examples 3 and 4 and Comparative Examples 1 to 10, while purging with nitrogen. The warping stress (25°C) of these cured films was measured with a thin-film stress measurement system (FLX-2320-S, from Toho Technology Corporation). The results are shown in Tables 3 and 4.

### (2) Evaluation of Adhesive Strength

The fabricated film was laminated onto an 8-inch silicon wafer using a film laminator (TEAM-100, from Takatori Corporation) and a silicon chip cut to 2 mm square was pressed against the film from above, after which the film was cured by heating in an oven at 230°C for 2 hours in Examples 1 and 2, at 150°C for 2 hours in Examples 5 and 6, and at 190°C for 2 hours in Examples 3 and 4 and Comparative Examples 1 to 10, while purging with nitrogen. Next, using a bond tester (Bond Tester Series 4000 (DS-100) from Nordson Advanced Technology), the chip was pushed laterally from the side at 23°C and a test rate of 200 µm/sec, and the bond strength when the chip separated from the substrate (die shear test) was measured. The results are shown in Tables 3 and 4.

### (3) Evaluation of Relative Permittivity and Dielectric Loss Tangent

The fabricated dry film was cured by heating in an oven at 230°C for 2 hours in Examples 1 and 2, at 150°C for 2 hours in Examples 5 and 6, and at 190°C for 2 hours in Examples 3 and 4 and Comparative Examples 1 to 10, while purging with nitrogen. The support film was then peeled from the cured film, and the relative permittivity (10 GHz, 25°C) and dielectric loss tangent (10 GHz, 25°C) were measured. The relative permittivity and dielectric loss tangent were measured by the cavity resonator method using a system from AET, Inc. The results are shown in Tables 3 and 4.

### (4) Evaluation of Tensile Strength

The fabricated dry film was cured by heating in an oven at 230°C for 2 hours in Examples 1 and 2, at 150°C for 2 hours in Examples 5 and 6, and at 190°C for 2 hours in Examples 3 and 4 and Comparative Examples 1 to 10, while purging with nitrogen. The support film was then peeled from the cured film, and the strength was measured using a tensile strength measurement device (Autoclave AGS-5kNG, from Shimadzu Corporation). The results are shown in Tables 3 and 4.

### (5) Evaluation of Reliability

Using the TEAM-100RF vacuum laminator (Takatori Corporation) and setting the degree of vacuum within the vacuum chamber to 80 Pa, the resin coating on the support film of the fabricated dry film was bonded to a CCL substrate having 10 mm × 10 mm square silicon chips mounted thereon. The temperature was set to 100°C. After returning the system to normal pressure, the substrate was removed from the vacuum laminator and the support film was peeled off. The film was cured by heating in an oven at 230°C for 2 hours in Examples 1 and 2, at 150°C for 2 hours in Examples 5 and 6, and at 190°C for 2 hours in Examples 3 and 4 and Comparative Examples 1 to 10, while purging with nitrogen. Next, using a dicing saw (DAD685, from DISCO; spindle speed, 40,000 rpm; cutting rate, 20 mm/sec) equipped with a dicing blade to cut the substrate, 20 mm × 20 mm test pieces were obtained such as to result in a silicon chip periphery of 5 mm. The resulting specimens (10 in each Example) were furnished to a heat cycling test (1,000 repeated cycles, each cycle consisting of holding the specimens at -50°C for 10 minutes and at 125°C for 10 minutes). Following the heat cycling test, the resin film was checked for peeling from the wafer and for the presence or absence of cracks. Cases in which there was no peeling whatsoever and cracks did not arise were rated as "○"; cases in which peeling arose in even one specimen were rated as "×"; cases in which cracks arose in even one specimen were rated as "×." The presence or absence of peeling and cracking was checked by top-down observation with an optical microscope and by cross-sectional scanning electron microscopy. The results are shown in Tables 3 and 4.

**[Table 3]**

| | | Example | | | | | |
|---|---|---|---|---|---|---|---|
| | | 1 | 2 | 3 | 4 | 5 | 6 |
| Warping stress (MPa) | | 4.8 | 4.2 | 3.4 | 4.7 | 4.1 | 3.3 |
| Adhesive strength (Mpa) | | 35 | 34 | 32 | 34 | 33 | 32 |
| Relative permittivity | | 2.5 | 2.3 | 2.2 | 2.3 | 2.2 | 2.2 |
| Dielectric loss tangent (×10⁻²) | | 0.5 | 0.4 | 0.3 | 0.5 | 0.4 | 0..2 |
| Tensile strength (Mpa) | | 36 | 34 | 32 | 35 | 33 | 31 |
| Reliability | Adhesion | ○ | ○ | ○ | ○ | ○ | ○ |
| | Crack resistance | ○ | ○ | ○ | ○ | ○ | ○ |

**[Table 4]**

| | | Comparative Example | | | | | | | | | |
|---|---|---|---|---|---|---|---|---|---|---|---|
| | | 1 | 2 | 3 | 4 | 5 | 6 | 7 | 8 | 9 | 10 |
| Warping stress (MPa) | | 5.5 | 5.6 | 6.3 | 6.5 | 9.5 | 9.3 | 6.6 | 9.7 | 5.3 | 5.3 |
| Adhesive strength (Mpa) | | 23 | 22 | 19 | 20 | 28 | 27 | 20 | 28 | 7 | 6 |
| Relative permittivity | | 2.8 | 2.7 | 2.8 | 2.7 | 2.9 | 2.7 | 2.8 | 2.8 | 2.7 | 2.8 |
| Dielectric loss tangent (×10⁻²) | | 1.5 | 1.4 | 1.5 | 1.4 | 1.6 | 1.5 | 1.5 | 1.4 | 1.5 | 1.6 |
| Tensile strength (Mpa) | | 20 | 18 | 19 | 18 | 26 | 23 | 20 | 25 | 6 | 5 |
| Reliability | Adhesion | × | × | × | × | ○ | ○ | × | ○ | × | × |
| | Crack resistance | ○ | ○ | ○ | ○ | × | × | ○ | × | ○ | ○ |

The above results demonstrate that the resin compositions of the invention, resin coatings obtained from these resin compositions, and dry films having a support film and such a resin coating on the support film give cured resin products which have a good adhesion to the base materials in substrates, electronic components, semiconductor devices and the like, particularly the base materials used in circuit boards, excellent toughness, excellent reliability as a coating for protecting electrical and electronic components, low relative permittivity and dielectric loss tangent, and little warpage.

## Claims

1. A resin composition comprising:
(A) a polymer that includes, on a main chain, a silphenylene skeleton, an epoxy group-containing isocyanuric acid skeleton and a norbornane skeleton, and
(B) an epoxy curing accelerator,
which composition, when heat cured, gives a cured resin product having a relative permittivity at 10 GHz of 2.5 or less and a dielectric loss tangent at 10 GHz of 0.005 or less.

2. The resin composition of claim 1, wherein the polymer (A) has repeating units of formula (A1) below and repeating units of formula (A2) below 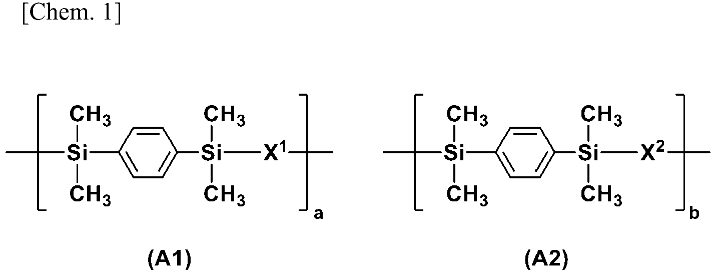 (wherein a and b are positive numbers that satisfy the conditions 0 < a < 1, 0 < b < 1 and a+b = 1, X¹ is a divalent group of formula (X1) below and X² is a divalent group of formula (X2) below 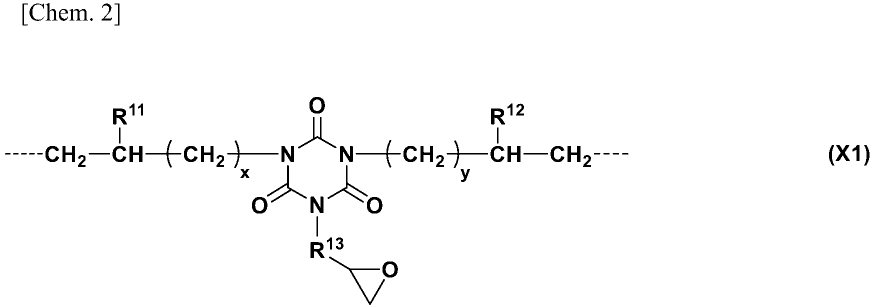 (wherein R¹¹ and R¹² are each independently a hydrogen atom or a methyl group, R¹³ is a hydrocarbylene group of 1 to 8 carbon atoms which may have an intervening ester bond or ether bond between a carbon-carbon bond, x and y are each independently integers from 0 to 7, and the dashed lines represent bonds) 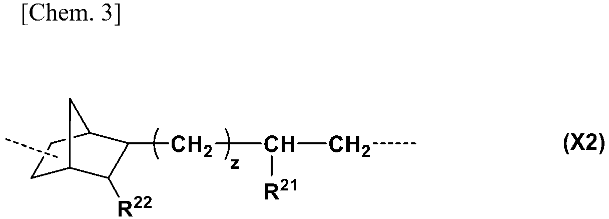 (wherein R²¹ and R²² are each independently a hydrogen atom or a saturated hydrocarbyl group of 1 to 20 carbon atoms which may include a heteroatom, z is an integer from 0 to 10, and the dashed lines represent bonds)).

3. The resin composition of claim 1, wherein the epoxy curing accelerator (B) is included in an amount of from 0.01 to 10 parts by weight per 100 parts by weight of the polymer (A).

4. The resin composition of claim 1, further comprising (C) a solvent.

5. The resin composition of claim 1, wherein heat curing is carried out at a curing temperature of between 100°C and 250°C.

6. The resin composition of claim 1, which is a coating material for protecting electrical and electronic components.

7. A resin coating obtained from the resin composition of any one of claims 1 to 6.

8. A dry film comprising a support film and, on the support film, the resin coating of claim 7.

9. A cured resin product obtained by heat-curing the resin coating of claim 7 at between 100°C and 250°C.
